# EUROPEAN PATENT SPECIFICATION

(11) **EP 3 775 314 B1**
(45) Date of publication and mention of the grant of the patent: **12.07.2023**
(21) Application number: 19714658.2
(22) Date of filing: 29.03.2019
(51) Int. Cl.: C23C 14/04, C23C 14/50, C23C 14/32, F01D 5/28, F01D 25/28

(54) **DEVICE AND METHOD FOR SELECTIVE VAPOR COATING OF A SUBSTRATE**
VORRICHTUNG UND VERFAHREN ZUR SELEKTIVEN DAMPFBESCHICHTUNG EINES SUBSTRATS
DISPOSITIF ET PROCÉDÉ DE REVÊTEMENT SÉLECTIF DE VAPEUR D'UN SUBSTRAT

(30) Priority: 29.03.2018 DE 102018107606
(43) Date of publication of application: 17.02.2021
(73) Proprietor: Oerlikon Surface Solutions AG, Pfäffikon, 8808 Pfäffikon, SZ (CH)
(72) Inventor: MEILER, Rudolf, 7220 Schiers (CH); BOURQUAIN, Christoph, 9475 Sevelen (CH)
(74) Representative: Misselhorn, Hein-Martin
(86) International application number: PCT/EP2019/058087
(87) International publication number: WO 2019/185914

(56) References cited:
- DE-A1-102015 105 169
- US-A1- 2011 086 233
- US-A1- 2013 149 450
- US-A1- 2013 264 169
- US-B1- 6 866 889
- US-B2- 7 837 843

## Description

### DEVICE AND METHOD FOR SELECTIVE VAPOR COATING OF A SUBSTRATE

The invention relates to a fixture for use in a physical vapor deposition coating process according to the preamble of claim 1. It is designed for synchronous coating of substrates which require a partial coating only. Such a process is preferably performed in a deposition chamber of a PVD coating machine.

Moreover, the invention relates to a PVD coating machine equipped with such a fixture, and a method for PVD coating under use of the inventive fixture.

### THE TECHNICAL BACKGROUND

Aircraft, helicopter and offroad vehicle gas turbine engines are often operated in a dusty environment where the gas turbine compressor rotor blades and stator vanes - collectively referred to as "turbine blades" - are exposed to erosive media such as sand. This concerns civil aircrafts, too, which sometimes have to manage the coming up of volcanic ash which is swept away by the jet streams right below the stratospheric area. In such cases detrimental mechanical erosion can occur. Moreover, downstream turbine blades may be excessively exposed to hot combustion gas. They are therefore prone to thermal overload and/or corrosion.

As a remedy erosion resistant hard material coatings and/or thermal load and/or corrosion reducing coatings such as, for example, TiN, TiCN, TiZrN, TiZrCN, TiAlN and TiAlCN are to be applied to the individual turbine blades. One typical method for the application of such hard material coatings is the cathodic arc physical vapor deposition with all its varieties.

Turbine blades can normally be divided into two portions, namely a first portion forming the true air foil and a second portion, called socket portion. It is used to attach the tubine blade to the disk or rotor part of the engine. The socket portion typically forms a dovetail for being nested into complementary dovetail slots on the disk or rotor portion of the engine. The dovetail area is not fully exposed to the flow of air or thermal load. Therefore, there is no need for protection of the dovetail area from detrimental erosive, thermal or corrosive effects. On the contrary. After a long period of time or rotating at high speeds, the dovetail walls exhibit a fatigue-related phenomenon referred to as fretting. Fretting has been found to be exacerbated by coatings applied to the air foil portion. For that reason, there is a need to coat said turbine blades selectively so that their socket portion will remain free from coating.

For other substrates than turbine blades there may be a similar demand of selective coating.

### THE STATE OF THE ART

In order to provide for the desired coating deposition on the air foil while shielding the socket portion of the turbine blade to be coated, EP 1 907 598 proposes the following:
One or more shields are provided. Each shield has a number of retainer openings designed that way that through each of the retainer openings a turbine blade can be stuck. In result, the air foil of each turbine blade extends from the shield into the coating deposition area, whereas the socket portion of each turbine blade extends from into a shielded area within the shield where no coating deposition can take place.

EP 1 907 598 teaches that for each socket portion the shielded area is designed as an individual, fully concluded compartment. Said compartment is a hollow space fully within the shield, whose walls completely embrace the single socket portion.

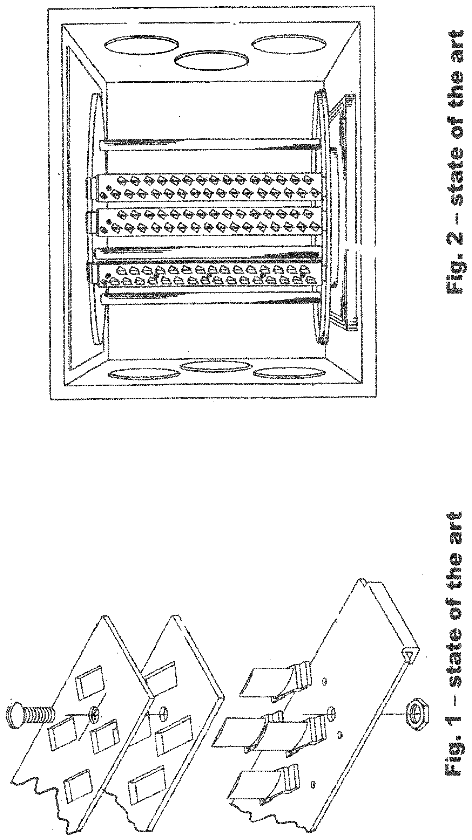

For that purpose, the shield is designed as a triple sandwich, at least, as illustrated by Fig. 1. The triple sandwich is composed of a base plate forming the closed bottom of the individual compartment, an intermediate plate with a retainer opening in the shape of a window forming the side walls of the compartment and a bezel plate forming the cover of the compartment with an outlet for the air foil portion shading the socket portion.

Said shields are mounted to a fixture in the shape of a carousel, as illustrated by Fig. 2. The carousel in turn is positioned within the process chamber of the coating machine, which is illustrated by Fig. 2, too. The circular targets fixed to the chamber's side walls of the coating machine can be easily seen. Between the targets acting as a cathode and the chambers walls acting as an anode or at least one separate anode an arc is burning. The material evaporated by the arc is accelerated in radial inward direction to the carousel carrying the substrates (normally under negative bias) hereinafter condensing on the substrates. The evaporated material is not able to intrude into each of the hollow spaces accommodating a socket since these are completely closed off. Further relevant prior art is disclosed in patent documents DE 10 2015 105169 A1 and US 2013/149450 A1.

That way a precise coating with a very reliable shielding is accomplished.

### THE OBJECT OF THE INVENTION

It is an object of the invention to teach a fixture for performing such a selective coating which allows shorter process cycles while the fixture is simpler and therefore itself more economic.

### THE INVENTIVE SOLUTION

In order to solve this problem, a particular fixture for use in a coating operation, preferably in the shape of a carousel, rotatable around a central axis is proposed according to claim 1. The fixture comprises a support structure to which a shield is detachably fixed.

The shield has a number of retainer openings. The retainer openings, and preferably all retainer openings, are designed that way that through each of the retainer openings a single substrate can be stuck. A first portion of each substrate extends from the shield into the coating deposition area. It is hold by the retainer opening separated from neighboured substrates to be coated, too. That way a very uniform coating is guaranteed.

A second portion of each object extends from the shield into a shielded area located behind the shield, i. e. on the backside of the shield. Behind the shield means located on that side of the shield that is averted to the surface of the shield being positioned face to face to the one or more targets. In said area located behind the shield which is the "shielded area" no coating deposition can take place.

The said shielded area is a hollow space. Preferably, the shielded area is one single hollow space - mostly with at least 0.03 m³ continuous volume.

Each recess in the backside of the shield, which accommodates the second portion of one substrate and which is tightened against unwanted deposition by the bezel formed in the shield, belongs to that hollow space. It communicates with the rest of the hollow space via a minimum clear cross section that is everywhere equal to or bigger than the maximum clear cross section of the assigned retainer opening.

In each case the hollow space jointly accommodates a plurality of second portions, without the second portions being divided by walls from each other or being individually "boxed".

Individually "boxed" means that the second portions are hold apart from each other with all sides of a second portion enclosed by walls.

Typically, the single hollow space has a tubular shape. Preferably, the longitudinal axis of said tubular shape extends coaxial or at least parallel to the longitudinal axis of the carousel, if any. This tubular shape is confined by the backside of the shield. The shield, for its part, is endless in its circumferential direction.

Since a plurality of second portions are accommodated within one and the same shielded hollow space, the loading with and the unloading of the substrates can be accomplished much quicker, compared to the individual "boxing" of each second portion of the substrates as taught by the state of the art.

Moreover, the complexity of the shield or shielding plates is reduced.

Finally, it becomes possible to use the shield already in the substrate preparation phase, for example in order to hold the substrates at place during sand blasting. This is because the simpler construction according to the invention bears a much lower risk that residual sand blasting grains are unintentionally freighted into the coating chamber. This makes the process much quicker since there is no necessity any more to load and unload the substrates to and from different fixtures - one for sandblasting and another, clean one, for coating.

### OPTIONS FOR ADVANCEMENT OF THE INVENTION

According to the invention the support structure possesses a central tube. Said tube, if not circular, may best have a cross section that is polygonal. The tube is surrounded, i. e. girded by the (outer) shield. It confines - together with the shield - said shielded area in the shape of the common hollow space which forms the interspace between the (outer) shield and the central tube. In other words, in this case the central tube is part of the shield, shielding the hollow space from unwanted vapor deposition.

Preferably, the support structure comprises a first and a second flange extending radially from the central tube. Said flanges forming a base for the attachment of the shield or shielding plates forming the multipart shield. That way a very quick and all time tight mounting of the shield, or the shielding plates forming it, becomes possible.

In most cases the flanges are interconnected by a number of support bars. The support bars themselves directly contact the shield. That way a firm and geometrically exact support of the detachable shield or shieling plates is provided. That way time is saved during mounting and unmounting of the shield or shielding plates that is required one time during each cycle.

It is according to the invention to form the shield by a plurality of shielding plates. Typically - when being in position ready for deposition operation - the lateral flanges of two in circumferential direction directly neighbored shielding plates are jointly sealing said hollow space, with or without involvement of a support bar. Sealing means here that a coating deposition in the hollow space is hindered.

Preferably, the shielding plates are - ideally on both main surfaces - planar panels, fully or at least essentially. Essentially means that local protrusions are irrelevant as long as flat support surfaces are formed.

It is advantageous if the aforementioned circumference of said flanges forms a polygon with a number of flat bases/supports for the attachment of the shielding plates.

A very preferred solution proposes a shield which comprises a base carrier with a number of windows. A number of exchangeable adapter plates are mounted to said base carrier. The adapter plates serve to partially close the windows in the base carrier - except for the retainer openings provided in the adapter plates. The adapter plates allow a very effective adaptation of the shield to different substrate geometries. It is not necessary anymore to manufacture a completely new shield. It is sufficient to provide adapter plates with a customized retainer opening. Preferably, an adapter plate can be mounted and unmounted tool-less to or from the base plate, ideally in different rotary positions. Tool-less means without welding, soldering or riveting and ideally without actuation of screws or press tools. In its narrowest sense tool-less means with "bare" hands carrying nothing than a pincer.

The outer circumference of the adapter plate is preferably round for that purpose. That way the adapter plate can be mounted in very different positions. That makes it easier to position the first portion of the substrate in an optimal orientation, i. e. in an orientation that guarantees an optimum in regard to the deposition result. A square, triangular or hexagonal circumference of the adapter plate can be considered for this purpose, too, even if less versatile.

It is preferred to assign a spring element to a retainer opening. The spring element is designed to contribute to immobilization of the substrate stuck through the retainer opening. The goal is an immobilization of the substrate relatively to the retainer opening.

A very preferred variant provides a special anchoring of the spring element. The anchoring to the base plate is designed that way that the spring element contributes to immobilization of the substrate to be coated as well as to immobilization of the adapter plate relative to the base carrier. That accelerates the placement of the substrates if small series of different substrates have to be coated.

Preferably, the shield or the shielding plate - or an adapter plate of the said components - is a sandwich of a front plate forming the bezel portion of each retainer opening and a back plate forming the retaining portion of each retainer opening.

Preferably, the contact area between the front plate and the back plate is sealed so that no debris or solid/fluidal cleaning agents (like sandblasting powder) can intrude between the plates.

### THE LIST OF FIGURES

Fig. 1 shows a shielding plate according to the state of the art.
Fig. 2 shows a deposition chamber equipped with a fixture according to the state of the art.
Fig. 3 shows an embodiment of a support structure according to the invention without a shield or shielding plates.
Fig. 4 shows the support structure according Fig. 3 with one exemplary shielding plate going to be mounted.
Fig. 5 shows the support structure according Fig. 3 fully equipped with shielding plates, i. e. in condition ready for deposition of a coating.
Fig. 6 shows an enlarged view to the backside of a shielding plate as carried by the support structure according to Fig. 5.
Fig. 7 shows an enlarged view to the upper portion of the frontside of the shielding plate shown by Fig. 6.
Fig. 8 shows a view to an alternative second embodiment of a shielding plate according to the invention.

### THE FIRST PREFERRED EMBODIMENT

### OVERVIEW

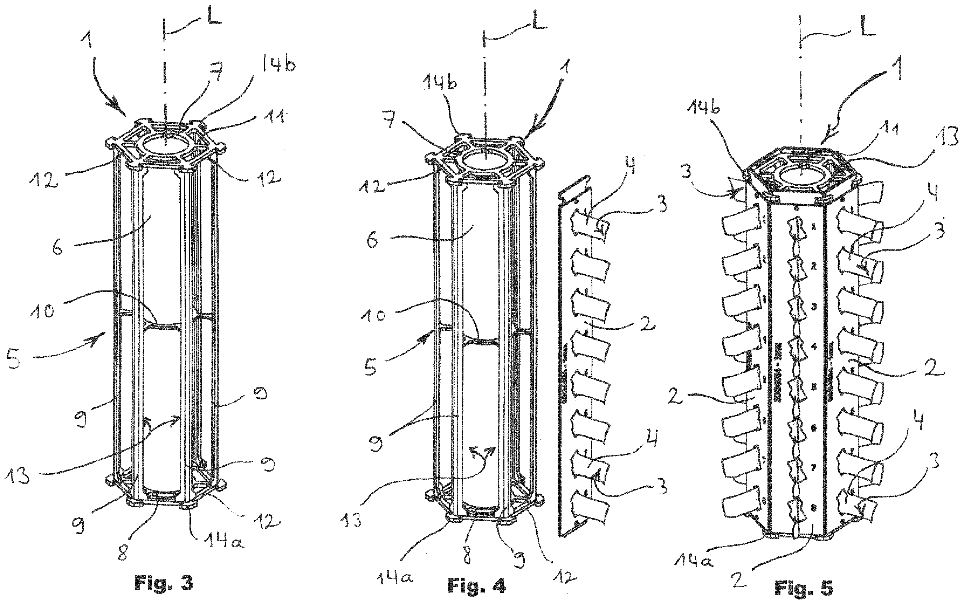

Figures 3 to 5 give a complete overview over an inventive fixture 1.

The fixture 1 carries a shield being composed here of a number of shielding plates 2. Each of the shielding plates 2 carries - preferably - a number of turbine blades 3. From each of the turbine blades 3 only the true air foil 4 is visible, which forms the so-called first portion and extends in radial outward direction into the deposition chamber, ready for coating by deposition.

Not shown by Figures 3 to 5 are the sockets of the turbine blades 3, which form the so-called second portions that are shielded against deposition. This fixture 1 carrying the substrates like turbine blades 3 is positioned in the deposition chamber of a deposition machine which may be designed and work in the same manner as already explained by means of Figure 2 for the state of the art.

### THE SUPPORT STRUCTURE

Figure 3 shows the support structure 5 to which the shielding plates 2 can be attached.

The support structure 5 is preferably designed as a rotatable carousel. The support structure 5 comprises a central tube 6. Normally, the central tube 6 has a completely closed circumferential surface, at least essentially. Small local holes, as used for fixing purposes, are not detrimental.

Preferably on the inside of the central tube, the bearings and maybe the drive for rotating the whole fixture 1 around its longitudinal axis L are accommodated. That way the bearings and the drive, if any, are protected from detrimental deposition.

From the central tube 6 at least a first flange 7 and a second flange 8 extend in radial outward direction. The flanges 7, 8 are attached to the opposite ends of the tube 6.

Said flanges 7, 8 could be designed as closed plates, however, that is not mandatory. In this particular case the flanges 7, 8 are designed with windows 11 in it in order to save material and weight. The existence of such windows 11 is not detrimental as long as they are positioned out of the intrusion area of the vapor.

As one can see, the circumference of each flange 7, 8 is preferably designed as a polygon or ideally as a hexagon or an octagon. Why this is preferred will become clear hereinafter.

The flanges 7 and 8 may be interconnected by means of support bars 9. Normally, the support bars contact the shielding plates 2 when those are put into their working position that means ready for deposition. Preferably together with the support bars 9 the flat surfaces 12 at the circumference of the flanges 7, 8 form in most cases a rectangular frame for receiving the backside of a shielding plate 2 in a tightening manner. The expression "tightening manner" does not mean a hermetic tightness. A tightness against intrusion of vapor in radial direction is sufficient. Even a slot can provide for such a tightness if it forms a kind of labyrinth blocking the straight path in radial direction.

As one can see from Figure 3 or 4, one or more intermediate supports 10 can be provided. The intermediate supports avoid that the support bars 9 are detrimentally prone to vibration. The intermediate supports 10 can be designed in a rod-like manner, as shown by Figure 3 or 4. Such is preferred.

Alternatively, the intermediate supports 10 could be designed as continuous plates, even without windows in it. That way they would divide the hollow space 13 in a "bulkhead" manner into - for example - two subsections, each accommodating a number of second portions. Such is not shown here and such is not preferred but mentioned to avoid circumvention.

As can be seen best by comparison of Figs. 3 and 4, the fixture 1 may be equipped with radially protruding foot plates 14a and maybe with comparable head plates 14b, too. Said plates, if any, may contribute to fixing or positioning of the shielding plates 2.

As a material for the construction of the support structure 5 preferably an austenitic steel is used, for example like EN 1.4301, or a corrosion resistant ferritic steel, as EN 1.4622, for example.

### THE JOINT HOLLOW SPACE BEING SHIELDED

In the light of what has been explained before, one recognizes that the shielding plates 2 closely grouped in circumferential direction around the central tube 6 confines together with the central tube 6 (in the area between the flanges 7, 8) a joint hollow space 13. This hollow space is here the radial interspace between the shielding plates 2 and the central tube 6.

The said hollow space is shielded against intrusion of vapor.

It jointly accommodates a plurality or, as here, all second portions of the substrates under processing - in case of turbine blades all their sockets which are not allowed to receive a coating.

Preferably said hollow space - allocated between the two said flanges 7, 8 - has a volume of more than 0.01 m³. In most cases the volume is hollow space in the range between 0.03 m³ to 1 m³. Typically the hollow space has a (fully or essentially) tubular shape, with the imagined "wall" of said tube, which preferably has a radial thickness between 0.08 m and 0.3 m everywhere, forms the hollow space.

### THE DESIGN OF THE SHIELD

As already mentioned above, the shield could theoretically be one single jacket that is wrapped with the required radial distance around the central tube 6.

However, such a design would be inconvenient for most application purposes. For that reason, it is preferred that a number of shielding plates 2 form together the shield in the shape of a jacket which is wrapped around the central tube 6 as mentioned above.

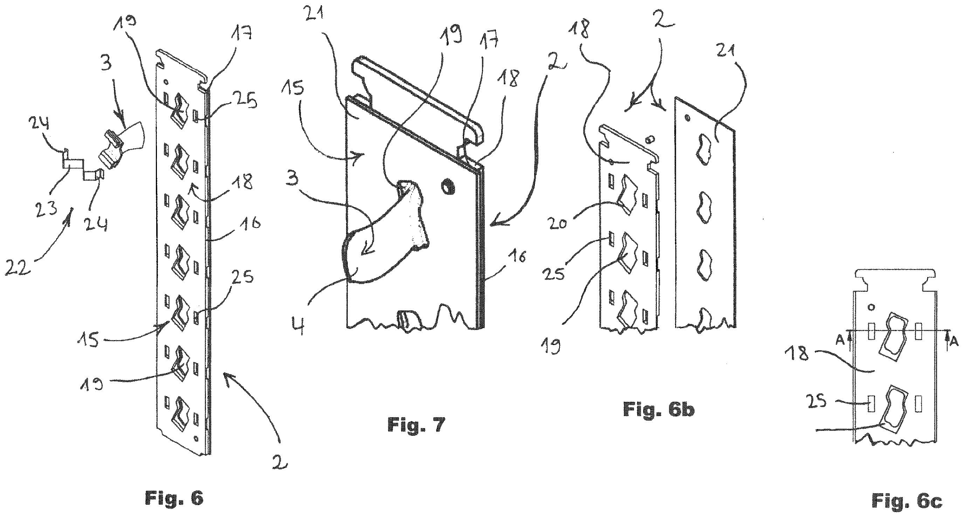

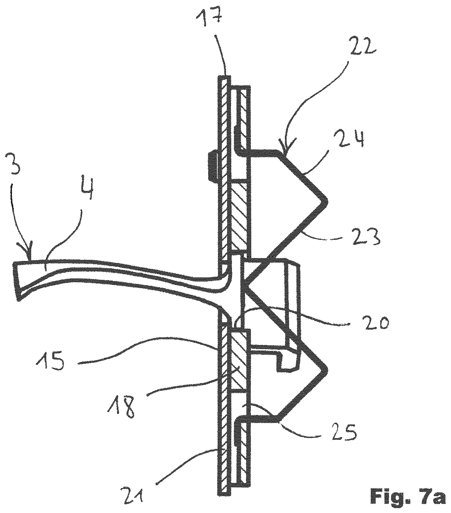

Preferably, each of the shielding plates 2 is designed as disclosed by Figure 6. Figure 7 illustrates how a turbine blade 3, forming the substrate to be coated here, is fixed to such a shielding plate 2 "ready for coating".

As easily can be seen, each shielding plate 2 processes preferably between 3 and 15 retainer openings 19. Each of the retainer openings 19 is designed in such a way that the substrate to be coated can be stuck through the retainer opening 19, see Figure 7.

In most cases such a shielding plate 2 is a (fully or essentially) flat plate with two main surfaces 15, two side surfaces 16 and two forehead surfaces 17. Typically the surface area of each of the two main surfaces 15 is at least seven times bigger than the surface area of each of the side surfaces 16 and the forehead surfaces 17. Typically, the surface area of each of the two side surfaces 16 is at least 5 times bigger than the surface area 17 of each of the forehead surfaces. This design awards a strip like appearance to the shielding plate.

Preferably, each of the shielding plates 2 is formed by a sandwich of a holding plate 18 and a bezel plate 21 which lie upon another with one of their main surfaces 15. This can best seen in Fig. 7.

The holding plate 18 carries, individually for each substrate to be coated, a retainer opening 19. The retainer opening 19 has the shape of the window going through the holding plate 18. The retainer opening 19 processes side walls 20 custom- made for the individual substrates to be coated. The side walls 20 embrace the second portion of the substrate to be coated in a form-fit manner. That is a precondition for holding the substrate to be coated in an exactly defined position.

As being self-evident from Figure 6, the window going through the holding plate 18 is not closed by a cover but remains open toward the inventive single hollow space.

The bezel plate 21 carries, individually for each substrate to be coated, a window that forms a bezel. For this purpose said window is smaller than the window going through the holding plate 18. Each of said windows of the bezel plate 21 is positioned that way that it is aligned with the assigned window going through the holding plate 18. The bezel plate 21 shades the second portion against the access by the vapor being generated in the process chamber.

In many cases the holding plate 18 and the bezel plate 21 are tightened against one another. That makes it possible to use the shielding plate 2 not only during the vapor deposition.

Instead, such a shielding plate 2 can already be used during the preparation of the substrates, in order to firmly hold it for example during sandblasting. If the two plates are tightened against one another, there is no risk that residual sand blasting material may be unintentionally conveyed into the deposition chamber where it would be detrimental.

Said tightening preferably is realized by soldering said two plates together, in some cases over the whole surface area of the two contacting main surfaces of the plates. A preferred solder for soldering is an Ag-based solder or another solder that is thermally stable even under load with the temperatures of more than 500° C and that is corrosion resistant, too.

In order to immobilize the second portion of the substrate to be coated within the window of the holding plate 18, a spring element 22 is provided. Preferably, an own spring element 22 is assigned to each of said windows in the holding plate 18.

As easily can be seen in Figure 6, the spring element 22 is configured here as a leaf spring that presses the second portion of substrate in direction perpendicular to the main surface 15 of the shielding plate.

Preferably, the spring element 22 has a V-shaped main portion 23 with two hooked legs 24 extending therefrom. The V-shaped main portion 23 presses against the second portion of the substrate. Each of the hooked legs 24 can be snapped into a fixation hole 25 provided for that purpose in the holding plate 18 at at least two sides of each window therein. As one can see, each fixation hole 25 is covered by the bezel plate 21 against direct access of by vapor in the deposition chamber.

As an alternative for said fixation holes 25 lashes can be provided that extend from the surface 15 of the shielding plate. Such lashes will be explained in greater detail later. However, for cost reasons the fixation holes are preferred, because they can easily be punched out, for example.

It has turned out that it is a particular advantage to manufacture the springs out of a steel that is creep-resistant and/or high-temperature-resistant against temperatures above 500° C. An ideal material is Nimonic 90.

Preferably, the holding plate 18 is equipped with form-fit elements for detachably fixing the shielding plate 2 to the support structure 5.

One of these form-fit elements, preferably the upper one, may be embodied as a C-shaped hanger claw or as a T-shaped protrusion, as shown by Figures 6 and 7. The T-shaped protrusion, too, can be hooked into the support structure. The other one of these form-fit elements, preferably the lower one, can be embodied as a tongue-like protrusion for snap- latching the shielding plate 2 to the support structure 5 or for clicking it to the support structure 5, see Figure 6.

Preferably, the bezel plate 21 itself does not embody said hanger claw, said T-shaped protrusion or said tongue-like protrusion, see Fig. 7.

In regard to the material used for the shield or shielding plates 2 it applies what has been said above in regard to the support structure 5.

### ANOTHER PREFERRED EMBODIMENT

Except for the differences explained hereinafter, the second preferred embodiment is identical to the first preferred embodiment explained above. For that reason, all of the above explanations for the first embodiment apply to the second embodiment, too, as long as the special features described hereinafter do not withstand.

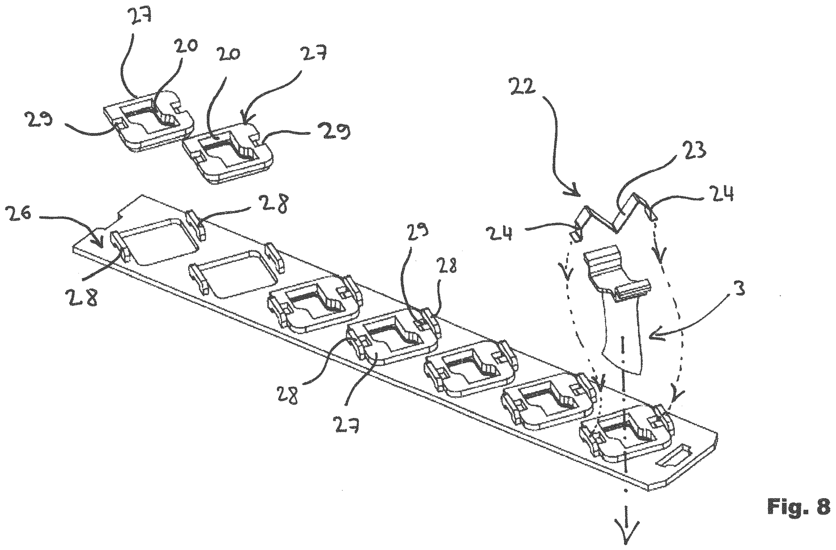

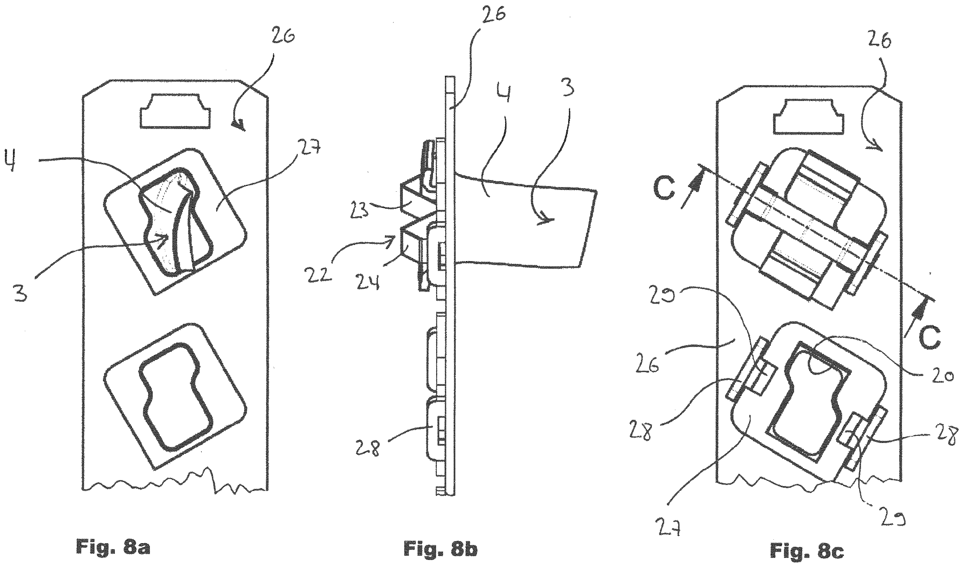

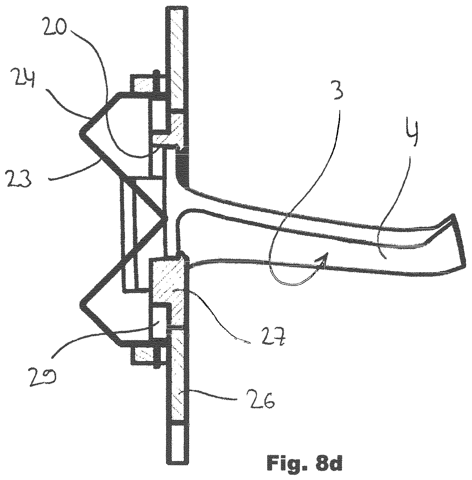

The striking difference of the second preferred embodiment is that for this embodiment more versatile shielding plates 2 are used, as shown by figure 8.

An according shielding plate 2 comprises a base carrier 26. The base carrier 26 carries a number of windows. Moreover, a number of adapter plates 27 is mounted to the base carrier 26 in order to close the said windows partially. The adapter plates a preferably mounted on the shielded backside of the base carrier. The only breakthrough remaining hereinafter in the area of the aforementioned window is the retainer opening
19 provided in each of the adapter plates 27.

So the advantage is that one and the same carrier 26 can be used for coating very different substrates.

In order to customize the carrier 26 to the different substrates to be coated, nothing else is required than accordingly customized adapter plates. This drastically reduces the manufacturing costs as well as the costs for storing - since no complete shielding plates 2 have to be stored anymore but only the much smaller adapter plates 27.

Preferably, one single adapter plate 27 is assigned to each individual substrate.

The adapter plates 27 themselves are designed in regard to their retainer opening 19 preferably according to what has been described above.

It is preferred here, too, to manufacture the adapter plates as a sandwich, preferably with two layers only. Such a sandwich is composed of a front plate that forms a bezel plate and a back plate that forms a carrier plate - as already described for the first embodiment. The carrier plate forms sidewalls which accommodate the second portion in form-fit manner. Preferably, the bezel plate and the carrier plate are tightened against each other, in most cases by soldering as explained above.

Preferably, the outer circumference of the adapter plates 27 is designed that way, that the adapter plates 27 can be mounted to the base carrier 26 in different rotary positions, that means for example in 6 o'clock position, 9 o'clock position or in 12 o'clock position, all related to a line orthogonal to the window in the base carrier 26.

That way it is possible to tune the orientation of the substrate's first portion within the deposition chamber as it is needed for the individual case - that means in order to obtain an optimized coating result.

The most preferred variant of the adapter plates 27 has a circular outer circumference, not shown by the Figs. Such an adapter plate can be mounted to the base carrier in every rotary position necessary. Alternatively, other adapter plates with quadratic, triangular, hexagonal or polygonal circumference are possible. Such adapter plates can also be mounted in different rotary positions, even if not so versatile.

The adapter plate 27 shown by Fig. 8 has a rectangular circumference. For that reason, it always has to be mounted in the same position.

In order to support the positioning and the fixing of the adapter plates 27, a number of lashes 28 are provided on the base carrier 26. Preferably, the lashes 28 guide two opposite circumferential sides of an adapter plate 27 in a form-fit manner. That way it is made sure that the positioning of each adapter plate 27 is precise.

Each of the lashes 28 serves for anchoring the spring element 22. Preferably, the spring element 22 is designed as already explained in connection with the first embodiment. If such a spring element 22 is used, every leg 24 of the spring element 22 can be nested into one lash 28.

That way the spring element 22 exerts pressure to the second portion of the substrate to be coated. The second portion of the substrate to be coated is that way pressed into the opening of the adapter plate 27. At the same time, the assembly of the adapter plate 27 and the substrate to be coated are pressed against the base carrier 26, altogether.

Preferably, each adapter plate 27 is equipped with two lateral recesses 29. Each recess 29 accommodates a part of a leg of the spring element 22, when mounted. That way the adapter plate 27 is secured by additional form-fit against slipping out of the base carrier 26 or (in this case) against slipping out of the guidance provided by the lashes 28.

As it is clearly visible when regarding Fig. 8, the big advantage of this design is that nothing else is required for synchronously fixing the substrate to be coated and the adapter plate than the tensioning of one single spring element. More exactly said, nothing else is necessary to fix the whole assembly than the nesting of the two legs of the leaf spring element 22 used here.

For sake of completeness it has to be said that it is an option to use here, too, the fixation holes 25 known from the first embodiment, instead of the lashes 28.

### LIST OF REFERENCE NUMBERS

- 1: fixture
- 2: shielding plate
- 3: turbine blade
- 4: air blade/air blade portion of the turbine blade
- 5: support structure
- 6: central tube
- 7: first flange
- 8: second flange
- 9: support bar
- 10: intermediate support
- 11: window in the flange
- 12: flat surface of a flange
- 13: hollow space
- 14a: foot plate
- 14b: head plate
- 15: main surface of the shielding plate
- 16: side surfaces of the shielding plate
- 17: forehead surfaces of the shielding plate
- 18: holding plate
- 19: retainer opening
- 20: side walls of the compartment
- 21: bezel plate
- 22: spring element
- 23: main portion
- 24: hooked legs
- 25: fixation hole
- 26: base carrier
- 27: adapter plate
- 28: lash
- 29: spring receiving recess in an adapter plate
- L: longitudinal axis

## Claims

1. A fixture (1) for use in a coating operation, comprising
a support structure (5) to which a shield is fixed,
the shield has a number of retainer openings (19), each designed that way that
through each of the retainer openings (19) an object to be treated can be stuck
so that a first portion of each object extends from the shield into the coating deposition area,
whereas a second portion of each object extends from the shield into a shielded area where no coating deposition can take place,
**characterized in that**
the shielding plates are grouped in circumferential direction around a central tube (6) defining a joint hollow space (13)¹,
that the said shielded area is the common hollow space (13) which jointly accommodates a plurality of second portions,
that the support structure (5) possesses the central tube (6) that is surrounded by the shield and that confines together with it the shielded area in the shape of the common hollow space (13)²,
that the shield is formed by a plurality of shielding plates (2), with lateral flanges of directly neighbored shielding plates (2) sealing together - with or without involvement of the support bar (9) - the shielded area in the shape of the common hollow space (13) when the shielding plates (2) are in position ready for deposition operation³.
¹ description page 12, pre-last paragraph
² original claim 2
³ original claim 5

2. A fixture (1) according to claim 1, **characterized in that** the support structure (5) comprises a first (7) and a second flange (8) extending from the central tube (6), said flanges (7, 8) forming a base for the attachment of the shield or shielding plates (2).

3. A fixture (1) according to claim 2, **characterized in that** the flanges (7, 8) are interconnected by support bars (9) that directly contact the shield.

4. A fixture (1) according to one of the preceding claims, **chara cterized in that** the shielding plates (2) are flat panels.

5. A fixture (1) according to claims 2 or 3, **characterized in that** said circumference of said flanges (7, 8) forms a polygon with a number of flat bases for the attachment of the shielding plates (2).

6. A fixture (1) according to one of the preceding claims, **characterized in that** the shield comprises a base carrier with a number of windows and a number of adapter plates mounted to the base carrier (26) to close the windows except for the retainer openings (19) provided in the adapter plates (27).

7. A fixture (1) according to claim 6, **characterized in that** an adapter plate (27) can be fixed to the base plate (26) in different rotary positions, whereas the outer circumference of the adapter plate (27) is preferably round for that purpose.

8. A fixture (1) according to one of the preceding claims, **characterized in that** to a retainer opening (19) a spring element (22) is assigned which is designed to immobilize the object stuck through the retainer opening (19).

9. A fixture (1) according to claim 8 together with one of the claims 8 or 9, **characterized in that** the spring element (22) is anchored, at least when tensioned, that way to the base carrier (26) that the spring element (22) contributes to immobilizing the object to be coated as well as the adapter plate (27) relative to the base carrier (26).

10. A fixture (1) according to one of the preceding claims, **characterized in that** the shield or the shielding plate (2) or an adapter plate (27) of the said components is a sandwich of a front plate forming the bezel portion of each retainer opening (19) and a back plate forming the retaining portion of each retainer opening (19), preferably the contact area between the front plate and the back plate being sealed, so that no debris or cleaning agents can intrude between the plates.

11. Physical vapor deposition coating machine with a fixture (1) according to one of the preceding claims.

12. Method for physical vapor deposition coating, **characterized in that** for holding the substrates a fixture (1) according one of the preceding claims is used, whereas the substrates to be coated are at first stuck through shielding plates (2), hereinafter the substrates are subjected to a cleaning process while being retained by said shielding plates (2), next the shielding plates (2) with the substrates retained are mounted to said fixture (1), which in turn is or will be positioned in the deposition chamber, hereinafter the physical vapor deposition is carried out.

## Patentansprüche

1. Haltevorrichtung (1) zur Verwendung in einem Beschichtungsvorgang, umfassend:
eine Haltestruktur (5), an der eine Abschirmung befestigt ist,
wobei die Abschirmung mehrere Halteöffnungen (19) aufweist, die jeweils so ausgestaltet sind, dass durch jede der Halteöffnungen (19) ein zu behandelnder Gegenstand gesteckt werden kann,
so dass sich jeweils ein erster Abschnitt des Gegenstands von der Abschirmung in den Abscheidungsbereich der Beschichtung erstreckt,
wobei sich jeweils ein zweiter Abschnitt des Gegenstands von der Abschirmung in einen abgeschirmten Bereich erstreckt, in dem keine Beschichtungsabscheidung stattfinden kann,
**dadurch gekennzeichnet,**
**dass** die Abschirmplatten in Umfangsrichtung um ein Mittelrohr (6) gruppiert sind, das einen gemeinsamen Hohlraum (13)¹ begrenzt,
**dass** der genannte abgeschirmte Bereich der gemeinsame Hohlraum (13) ist, der mehrere zweite Abschnitte zusammen aufnimmt,
**dass** die Haltestruktur (5) das Mittelrohr (6) aufweist, das von der Abschirmung umgeben wird und das gemeinsam mit dieser den abgeschirmten Bereich in Form des gemeinsamen Hohlraums (13)² begrenzt,
**dass** die Abschirmung durch eine Vielzahl von Abschirmplatten (2) gebildet wird, wobei seitliche Flansche unmittelbar benachbarter Abschirmplatten (2) - mit oder ohne Einbeziehung der Tragschiene (9) - den abgeschirmten Bereich in Form des gemeinsamen Hohlraums (13) gemeinsam abdichten, wenn die Abschirmplatten (2) in der für den Abscheidungsvorgang³ bereiten Position sind.
¹ Beschreibung Seite 12, vorletzter Absatz
² ursprünglicher Anspruch 2
³ ursprünglicher Anspruch 5

2. Haltevorrichtung (1) nach Anspruch 1, **dadurch gekennzeichnet, dass** die Haltestruktur (5) einen ersten (7) und einen zweiten Flansch (8) aufweist, die sich vom Mittelrohr (6) erstrecken, wobei die Flansche (7, 8) eine Fußplatte zur Befestigung der Abschirmung bzw. der Abschirmplatten (2) bilden.

3. Haltevorrichtung (1) nach Anspruch 2, **dadurch gekennzeichnet, dass** die Flansche (7, 8) durch Stützstäbe (9) miteinander verbunden sind, die direkt an der Abschirmung anliegen.

4. Haltevorrichtung (1) nach einem der vorhergehenden Ansprüche, **dadurch gekennzeichnet, dass** die Abschirmplatten (2) ebene Platten sind.

5. Haltevorrichtung (1) nach Anspruch 2 oder 3, **dadurch gekennzeichnet, dass** der Umfang der Flansche (7, 8) ein Vieleck mit mehreren ebenen Fußplatten zur Befestigung der Abschirmplatten (2) bildet.

6. Haltevorrichtung (1) nach einem der vorhergehenden Ansprüche, **dadurch gekennzeichnet, dass** die Abschirmung aus einem Grundträger mit mehreren Fenstern und mehreren am Grundträger (26) montierten Adapterplatten besteht, um die Fenster bis auf die in den Adapterplatten (27) vorgesehenen Halteöffnungen (19) zu schließen.

7. Haltevorrichtung (1) nach Anspruch 6, **dadurch gekennzeichnet, dass** eine Adapterplatte (27) an der Grundplatte (26) in verschiedenen Drehpositionen befestigt werden kann, wobei der Außenumfang der Adapterplatte (27) zu diesem Zweck vorzugsweise rund ist.

8. Haltevorrichtung (1) nach einem der vorhergehenden Ansprüche, **dadurch gekennzeichnet, dass** ein Federelement (22), das dazu ausgelegt ist, den durch die Halteöffnung (19) gesteckten Gegenstand zu fixieren, einer Halteöffnung (19) zugeordnet ist.

9. Haltevorrichtung (1) nach Anspruch 8 in Verbindung mit einem der Ansprüche 8 oder 9, **dadurch gekennzeichnet, dass** das Federelement (22) zumindest im gespannten Zustand so am Grundträger (26) verankert ist, dass das Federelement (22) dazu beiträgt, den zu beschichtenden Gegenstand sowie die Adapterplatte (27) bezüglich des Grundträgers (26) zu fixieren.

10. Haltevorrichtung (1) nach einem der vorhergehenden Ansprüche, **dadurch gekennzeichnet, dass** die Abschirmung bzw. die Abschirmplatte (2) oder eine Adapterplatte (27) der genannten Komponenten ein Sandwich aus einer Frontplatte, die jeweils den Blendenabschnitt der Halteöffnung (19) bildet, und einer Rückplatte, die jeweils den Halteabschnitt der Halteöffnung (19) bildet, ist, wobei vorzugsweise der Kontaktbereich zwischen der Frontplatte und der Rückplatte abgedichtet ist, so dass kein Schmutz oder Reinigungsmittel zwischen die Platten eindringen kann.

11. Maschine zur PVD-Beschichtung mit einer Haltevorrichtung (1) nach einem der vorhergehenden Ansprüche.

12. Verfahren zur Beschichtung mittels physikalischer Gasphasenabscheidung, **dadurch gekennzeichnet, dass** zum Halten der Substrate eine Haltevorrichtung (1) nach einem der vorhergehenden Ansprüche verwendet wird, wobei die zu beschichtenden Substrate zunächst durch Abschirmplatten (2) hindurchgesteckt werden, die Substrate anschließend einem Reinigungsprozess unterzogen werden, während sie von den Abschirmplatten (2) gehalten werden, und anschließend die Abschirmplatten (2) mit den gehaltenen Substraten an der Haltevorrichtung (1) montiert werden, die wiederum in der Abscheidungskammer positioniert ist oder wird, und anschließend die physikalische Gasphasenabscheidung durchgeführt wird.

## Revendications

1. Dispositif de fixation (1) destinée à être utilisée dans un processus de revêtement, comprenant
une structure de support (5) sur laquelle est fixé un blindage,
le blindage a un certain nombre d'ouvertures de retenue (19), chacune étant conçue de telle manière qu'un objet à traiter peut être inséré à travers chacune des ouvertures de retenue (19),
de sorte qu'une première partie de chaque objet s'étend du blindage vers la zone de dépôt du revêtement,
tandis qu'une seconde partie de chaque objet s'étend du blindage vers une zone blindée où aucun dépôt de revêtement ne peut avoir lieu,
**caractérisé en ce que**
les plaques de blindage sont regroupées en direction circonférentielle autour d'un tube central (6) définissant un espace creux commun (13)¹,
que ladite zone blindée est l'espace creux commun (13) qui reçoit conjointement une pluralité de secondes parties,
que la structure de support (5) possède le tube central (6) qui est entouré par le blindage et qui confine avec celui-ci la zone blindée en forme d'espace creux commun (13)²,
**en ce que** le blindage est formé par une pluralité de plaques de blindage (2), les brides latérales de plaques de blindage (2) directement adjacentes étanchant ensemble - avec ou sans participation de la barre de support (9) - la zone blindée en forme d'espace creux commun (13) lorsque les plaques de blindage (2) sont en position prêtes pour le processus de dépôt³.
¹ description page 12, avant-dernier paragraphe
² revendication originale 2
³ revendication originale 5

2. Le dispositif de fixation (1) selon la revendication 1, **caractérisée en ce que** la structure de support (5) comprend une première (7) et une seconde bride (8) s'étendant depuis le tube central (6), lesdites brides (7, 8) formant une base pour la fixation du blindage ou des plaques de blindage (2).

3. Le dispositif de fixation (1) selon la revendication 2, **caractérisée en ce que** les brides (7, 8) sont reliées l'une à l'autre par des barres de support (9) qui sont directement en contact avec le blindage.

4. Le dispositif de fixation (1) selon l'une des revendications précédentes, **caractérisée en ce que** les plaques de blindage (2) sont des panneaux plats.

5. Le dispositif de fixation (1) selon l'une des revendications 2 ou 3, **caractérisée en ce que** ladite circonférence desdites brides (7, 8) forme un polygone ayant un certain nombre de bases plates servant à la fixation des plaques de blindage (2).

6. Le dispositif de fixation (1) selon l'une des revendications précédentes, **caractérisé en ce que** le blindage comprend un support de base avec un certain nombre de fenêtres et un certain nombre de plaques adaptatrices montées sur le support de base (26) pour fermer les fenêtres à l'exception des ouvertures de retenue (19) prévues dans les plaques adaptatrices (27).

7. Le dispositif de fixation (1) selon la revendication 6, **caractérisée en ce qu'**une plaque adaptatrice (27) peut être fixée à la plaque de base (26) dans différentes positions de rotation, tandis que la circonférence extérieure de la plaque adaptatrice (27) est de préférence ronde pour ce but.

8. Le dispositif de fixation (1) selon l'une des revendications précédentes, **caractérisée en ce qu**'un élément à ressort (22) destiné à immobiliser l'objet inséré à travers l'ouverture de retenue (19) est associé à une ouverture de retenue (19).

9. Le dispositif de fixation (1) selon la revendication 8 conjointement avec l'une des revendications 8 ou 9, **caractérisée en ce que** l'élément à ressort (22) est ancré au support de base (26), au moins lorsqu'il est tendu, de telle manière que l'élément à ressort (22) contribue à immobiliser l'objet à revêtir ainsi que la plaque adaptatrice (27) par rapport au support de base (26).

10. Le dispositif de fixation (1) selon l'une des revendications précédentes, **caractérisée en ce que** le blindage ou la plaque de blindage (2) ou une plaque adaptatrice (27) desdits composants est un sandwich d'une plaque frontale formant la partie de masque de chaque ouverture de retenue (19) et d'une plaque arrière formant la partie de retenue de chaque ouverture de retenue (19), de préférence la zone de contact entre la plaque frontale et la plaque arrière étant étanchée de sorte qu'aucun débris ou agent de nettoyage ne puisse pénétrer entre les plaques.

11. Machine servant au revêtement par dépôt physique en phase vapeur avec un dispositif de fixation (1) selon l'une des revendications précédentes.

12. Procédé de revêtement par dépôt physique en phase vapeur, **caractérisé en ce qu'o**n utilise un dispositif de fixation (1) selon l'une des revendications précédentes pour tenir les substrats, tandis que les substrats à revêtir sont d'abord insérés à travers des plaques de blindage (2), ci-après les substrats sont soumis à un processus de nettoyage tout en étant retenus par lesdites plaques de blindage (2), puis les plaques de blindage (2) avec les substrats retenus sont montées sur ledit dispositif de fixation (1), qui à son tour est ou sera positionné dans la chambre de dépôt, ensuite le dépôt physique en phase vapeur est effectué.
